# EUROPÄISCHE PATENTANMELDUNG

(11) **EP 4 116 639 A1**
(43) Veröffentlichungstag der Anmeldung: **11.01.2023**
(21) Anmeldenummer: 21020348.5
(22) Anmeldetag: 05.07.2021
(51) Int. Cl.: F25B 9/00, F25B 9/08, F25B 9/10, F25B 1/10, F25B 40/00

(54) **VORKÜHLKREIS UND VERFAHREN ZUR HELIUM-KÄLTEVERSORGUNG**

(71) Anmelder: Linde Kryotechnik AG, 8422 Pfungen (CH)
(72) Erfinder: Decker, Lutz, Winterthur (CH)
(74) Vertreter: Lu, Jing

(57) **Zusammenfassung**

Bereitgestellt wird ein Vorkühlkreis zur Helium-Kälteversorgung wenigstens eines zu kühlenden Verbrauchers (72), umfassend eine Zuleitung (30) und eine Rückleitung (32), die über eine Kälteabgabeeinrichtung (10) miteinander verbunden sind, wobei die Kälteabgabeeinrichtung eingerichtet ist, Wärme mit dem wenigstens einen zu kühlenden Verbraucher zu tauschen; eine Helium-Kühlanlage (2), die eingerichtet ist, Wärme an die Umgebung abzugeben, rückströmendes Helium zu verdichten und das verdichtete Helium in die Zuleitung zu leiten; einen ersten und einen zweiten Kühlbadbehälter (34, 36), wobei die Zuleitung durch einen in einem Fußraum des ersten Kühlbadbehälters (34) angeordneten ersten Wärmetauscher (40) und in Richtung der Kälteabgabeeinrichtung nachfolgend durch einen in einem Fußraum des zweiten Kühlbadbehälters (36) angeordneten zweiten Wärmetauscher (42) verläuft, und wobei ein Kopfraum des ersten Kühlbadbehälters über eine Rückführleitung (18) mit der Helium-Kühlanlage verbunden ist; einen Ejektor (50), wobei eine Treibstrom-Öffnung mit der Rückleitung verbunden ist, eine Ansaug-Öffnung mit einem Kopfraum des zweiten Kühlbadbehälters verbunden ist, und eine Ausstoß-Öffnung mit dem Kopfraum des ersten Kühlbadbehälters verbunden ist, wobei der Ejektor eingerichtet ist, von der Kälteabgabeeinrichtung rückströmendes Helium als Treibstrom zu verwenden, um Heliumdampf aus dem zweiten Kühlbadbehälter anzusaugen und auf den Druck des ersten Kühlbadbehälters anzuheben.

## Beschreibung

Die Erfindung betrifft einen Vorkühlkreis und ein Verfahren zur Helium-Kälteversorgung wenigstens eines zu kühlenden Verbrauchers.

### Stand der Technik

In der Grundlagenforschung wie auch zur Kühlung von Quantencomputern werden Kühltemperaturen weit unterhalb von 1 K benötigt. Dazu werden nach heutigem Stand der Technik Mischungskryostate eingesetzt, die mit Pulsationsrohr-, Sterling- oder Gifford-McMahon-Kühler bis in den Bereich von 3 - 4 K vorgekühlt werden. Eine tiefe Vorkühltemperatur ist Voraussetzung für die Effizienz des Mischungskryostats. Die Kälteleistung dieser Vorkühlmaschinen liegt im Bereich von nur wenigen Watt mit zusätzlicher Kühlleistung bei 50 K als Schildkühlung. Daher werden Mischungskryostate z.B. jeweils mit 2 Pulsationsrohrkühlern ausgerüstet.

Mit dem Fortschritt insbesondere in der Quantencomputer-Forschung steigt der Leistungsbedarf an Vorkühlung stark an. Der Wirkungsgrad der oben genannten Vorkühlsysteme ist jedoch sehr niedrig. Dies fällt bei kleineren Anwendungen nicht sonderlich ins Gewicht, bestimmend ist hier der generell hohe Anschaffungspreis des Mischungskryostaten. Bei mehrfacher Anordnung der Vorkühlsysteme steigt jedoch der Energieverbrauch linear an, so dass die resultierenden Betriebskosten signifikant werden. Sollen zusätzlich mehrere Mischungskryostate für z.B. mehrere Quantencomputer betrieben werden, vervielfältigt sich das Problem.

Es besteht also Bedarf an einem effizienten Vorkühlsystem, das in der Lage ist, ein oder mehrere Mischungskryostate mit Kälte, insbesondere Heliumkälte, möglichst tiefer Temperatur zu versorgen, wobei die Kältezufuhr bzw. Kälteleistung, insbesondere im Falle mehrerer Mischungskryostate, variabel sein sollte.

### Offenbarung der Erfindung

Diese Aufgabe wird gelöst durch einen Vorkühlkreis und ein Verfahren zur Helium-Kälteversorgung wenigstens eines zu kühlenden Verbrauchers mit den Merkmalen der unabhängigen Ansprüche. Abhängige Ansprüche betreffen bevorzugte Ausführungsformen.

Der (geschlossene) Vorkühlkreis zur Helium-Kälteversorgung wenigstens eines zu kühlenden Verbrauchers, umfasst eine Zuleitung und eine Rückleitung, die über eine Kälteabgabeeinrichtung miteinander verbunden sind, wobei die Kälteabgabeeinrichtung dazu eingerichtet ist, Wärme mit dem wenigstens einen zu kühlenden Verbraucher zu tauschen; eine Helium-Kühlanlage, die dazu eingerichtet ist, Wärme an die Umgebung abzugeben, rückströmendes Helium zu verdichten und das verdichtete Helium in die Zuleitung zu leiten; einen ersten und einen zweiten Kühlbadbehälter, wobei die Zuleitung durch einen in einem Fußraum des ersten Kühlbadbehälters angeordneten ersten Wärmetauscher und in Richtung der Kälteabgabeeinrichtung nachfolgend durch einen in einem Fußraum des zweiten Kühlbadbehälters angeordneten zweiten Wärmetauscher verläuft, und wobei ein Kopfraum des ersten Kühlbadbehälters über eine Rückführleitung mit der Helium-Kühlanlage verbunden ist, um dieser das rückströmende Helium zuzuführen; und einen Ejektor mit einer Treibstrom-Öffnung, einer Ansaug-Öffnung und einer Ausstoß-Öffnung, wobei die Treibstrom-Öffnung mit der Rückleitung verbunden ist, die Ansaug-Öffnung mit einem Kopfraum des zweiten Kühlbadbehälters verbunden ist, und die Ausstoß-Öffnung mit dem Kopfraum des ersten Kühlbadbehälters verbunden ist, wobei der Ejektor eingerichtet ist, durch die Rückleitung von der Kälteabgabeeinrichtung rückströmendes Helium als Treibstrom zu verwenden, um Heliumdampf aus dem zweiten Kühlbadbehälter anzusaugen und auf den Druck des ersten Kühlbadbehälters anzuheben. Der Begriff "Fußraum" ist auch als "Sumpfraum" bekannt.

Durch einen erfindungsgemäßen Vorkühlkreis wird ermöglicht, das von dem Kompressionssystem verdichtete Helium in einem überkritischen Zustand zum Verbraucher zu leiten, so dass das Auftreten eines schwer zu kontrollierenden Zweiphasengemisches (gasförmiges und flüssiges Helium) vermieden wird. Dabei weist das Helium nach Durchlaufen des Verbrauchers immer noch einen ausreichenden Druck auf, um mittels des Ejektors den Heliumdampf des zweiten Kühlbadbehälters auf den Druck des ersten Kühlbadbehälters anzuheben. Insgesamt wird so der Einsatz einer mehrstufigen Badkühlung ermöglicht, so dass eine tiefe Temperatur erreicht werden kann.

Bevorzugt handelt es sich bei dem wenigstens einen zu kühlenden Verbraucher um einen Mischungskryostat.

Bevorzugt ist eine Nebenrückleitung vorgesehen, die nach dem Verbraucher von der Rückleitung abgezweigt ist, durch einen in dem Fußraum des ersten Kühlbadbehälters angeordneten vierten Wärmetauscher verläuft, und vor der Treibstrom-Öffnung des Ejektors in die Rückleitung mündet, wobei weiter bevorzugt in der Nebenrückleitung und/oder in der Rückleitung parallel zur Nebenrückleitung wenigstens ein Ventil angeordnet ist, um den Durchfluss durch die Nebenrückleitung zu steuern. Dies ermöglicht einen Teillastbetrieb des Vorkühlkreises, so dass insbesondere eine variable Anzahl von Verbrauchern mit Kälte versorgt werden kann.

Bevorzugt umfasst der Vorkühlkreis einen dritten Kühlbadbehälter, wobei die Zuleitung nachfolgend auf den zweiten Kühlbadbehälter durch einen in einem Fußraum des dritten Kühlbadbehälters angeordneten dritten Wärmetauscher verläuft, und wobei ein Kopfraum des dritten Kühlbadbehälters mit einer Vakuumpumpe verbunden ist, die dazu eingerichtet ist, Heliumdampf aus dem Kopfraum abzupumpen und der Helium-Kühlanlage zuzuführen, wobei bevorzugt ein Verdichter vorgesehen ist, der ein Druckniveau des abgepumpten Heliums auf ein Druckniveau der Helium-Kühlanlage anhebt. Hierdurch wird ermöglicht, eine tiefere Temperatur zu erreichen.

Bevorzugt ist der erste Kühlbadbehälter dazu eingerichtet, im Fußraum flüssiges Helium aufzunehmen, das im Gleichgewicht mit Heliumdampf im Kopfraum steht, wobei ein im Bereich von 1,0 bar bis 1,5 bar liegt, und der zweite Kühlbadbehälter ist dazu eingerichtet, im Fußraum flüssiges Helium aufzunehmen, das im Gleichgewicht mit Heliumdampf im Kopfraum steht, wobei ein zweiter Gleichgewichtsdruck bevorzugt im Bereich von 0,4 bar bis 0,65 bar liegt, und gegebenenfalls ist der dritte Kühlbadbehälter dazu eingerichtet, im Fußraum flüssiges Helium aufzunehmen, das im Gleichgewicht mit Heliumdampf im Kopfraum steht, wobei ein dritter Gleichgewichtsdruck bevorzugt im Bereich von 0,1 bar bis 0,3 bar liegt. Im zweistufigen Fall lassen sich so Temperaturen kleiner oder gleich 3,6 K erreichen. Im dreistufigen Fall lassen sich so Temperaturen kleiner 3 K erreichen
Bevorzugt umfasst die Helium-Kühlanlage wenigstens einen Kompressor und ist dazu eingerichtet Helium auf einen Druck im Bereich von 7 bar bis 18 bar, bevorzugt im Bereich von 10 bar bis 15 bar, zu verdichten. Durch den hohen Druck lässt sich das Entstehen eines Zweiphasen-Heliumgemisches vermeiden.

Bevorzugt umfasst die Helium-Kühlanlage ein Wärmetauschersystem, wobei das rückströmende Helium im Gegenstrom zum verdichteten Helium durch das Wärmetauschersystem geleitet wird.

Weiterhin umfasst bevorzugt die Kälteabgabeeinrichtung einen Schildkreislauf umfasst; und die Helium-Kühlanlage ist dazu eingerichtet, einen Heliumschildstrom bereitzustellen, wobei der Heliumschildstrom von der Helium-Kühlanlage zum Schildkreislauf geleitet und von diesem zurück zur Helium-Kühlanlage geleitet wird. Dadurch kann eine äußere Schild-Kühlung des Verbrauchers versorgt werden.

Bevorzugt ist die Kälteabgabeeinrichtung dazu eingerichtet, Wärme mit mehreren zu kühlenden Verbrauchern zu tauschen, wobei die Verbraucher unabhängig voneinander mit der Zuleitung und der Rückleitung verbindbar und trennbar sind. Es ist also möglich, die Anzahl der Verbraucher zu variieren.

Eine erfindungsgemäße Tieftemperaturanlage umfasst einen erfindungsgemäßen (geschlossenen) Vorkühlkreis und wenigstens einen Mischungskryostat, der als der wenigstens eine zu kühlenden Verbraucher mit der Kälteabgabeeinrichtung verbunden ist; wobei bevorzugt die Kälteabgabeeinrichtung so eingerichtet ist, dass die Zuleitung und die Rückleitung mit wenigstens einem Heliumbad des wenigstens einen Mischungskryostats verbunden sind.

In einem erfindungsgemäßen Tieftemperaturverfahren wird wenigstens eine Probe in dem wenigstens einen Mischungskryostat einer erfindungsgemäßen Tieftemperaturanlage platziert und auf eine Temperatur unter 1 K gekühlt.

Das erfindungsgemäße Verfahren zur Helium-Kälteversorgung wenigstens eines zu kühlenden Verbrauchers, umfasst ein Verdichten rückströmenden Heliums; ein Leiten des verdichteten Heliums durch ein erstes Kühlbad und ein nachfolgendes zweites Kühlbad, um Helium in einem überkritischen Zustand zu erhalten; ein Leiten des überkritischen Heliums zu einer Kälteabgabeeinrichtung, die mit dem wenigstens einen zu kühlenden Verbraucher in Wärmeaustausch steht; ein Leiten eines Rückstroms des Heliums von der Kälteabgabeeinrichtung zu einer Treibstromöffnung eines Ejektors; ein Ansaugen eines zweiten Heliumdampfes, der im Gleichgewicht mit dem zweiten Kühlbad steht, mittels des Ejektors und Zuführen zu einem ersten Heliumdampf, der im Gleichgewicht mit dem ersten Kühlbad steht; und ein Ableiten des ersten Heliumdampfes, um das rückströmende Helium zu erhalten.

Bevorzugt umfasst das Verfahren weiterhin ein Abzweigen mindestens eines Teils des Rückstroms, um einen Nebenrückstrom zu bilden; ein Leiten des Nebenrückstroms durch das erste Kühlbad und anschließend in den Rückstrom.

Vorzugsweise umfasst das Verfahren ein Leiten des verdichteten Heliums durch ein drittes Kühlbad nach dem zweiten Kühlbad.

In dieser Anmeldung wird zur Vereinfachung von einer 'Kälteversorgung' oder einer 'Kälteabgabe' durch den Vorkühlkreis gesprochen, bzw. davon gesprochen, dass 'ein Verbraucher mit Kälte versorgt wird' oder dass 'Kälte an einen Verbraucher abgegeben wird'. Dies ist jeweils in dem Sinne zu verstehen, dass durch den Vorkühlkreis Wärme vom Verbraucher aufgenommen bzw. abgeführt wird (mittels einer jeweiligen Wärmetauschvorrichtung).

Der Begriff 'Leitung' bzw. 'leiten' bezieht sich auf Leitungen für Fluide, insbesondere für Helium, das vorzugsweise gasförmig ist. Es sind also Rohre bzw. Rohrleitungen gemeint. Ebenso bezieht sich der Begriff 'verbunden' darauf, dass eine fluidische Verbindung über eine (Rohr-)Leitung besteht. In allen Fällen können Ventile vorgesehen sein, die den Fluidfluss durch die Leitung beeinflussen bzw. steuern.

Die Erfindung wird nachfolgend unter Bezugnahme auf die beigefügten Zeichnungen näher erläutert, welche die vorliegende Erfindung und ihre Merkmale gegenüber dem Stand der Technik veranschaulichen.

### Kurze Beschreibung der Zeichnungen

Figur 1 zeigt einen Vorkühlkreis mit zweistufiger Badkühlung gemäß einer bevorzugten Ausführungsform der Erfindung;
Figur 2 zeigt einen Vorkühlkreis mit einer variabel ausgelegten zweistufigen Badkühlung gemäß einer anderen bevorzugten Ausführungsform der Erfindung;
Figur 3 zeigt einen Vorkühlkreis mit einer dreistufigen Badkühlung gemäß einer weiteren bevorzugten Ausführungsform der Erfindung;
Figur 4 zeigt einen Vorkühlkreis mit einer variabel ausgelegten dreistufigen Badkühlung gemäß einer weiteren bevorzugten Ausführungsform der Erfindung;
Figur 5 zeigt eine Kälteabgabeeinrichtung, die mit zu kühlenden Verbrauchern, insbesondere Mischungskryostaten, verbunden ist; und
Figur 6 zeigt das erfindungsgemäße Verfahren gemäß einer bevorzugten Ausführungsform.

### Ausführungsform(en) der Erfindung

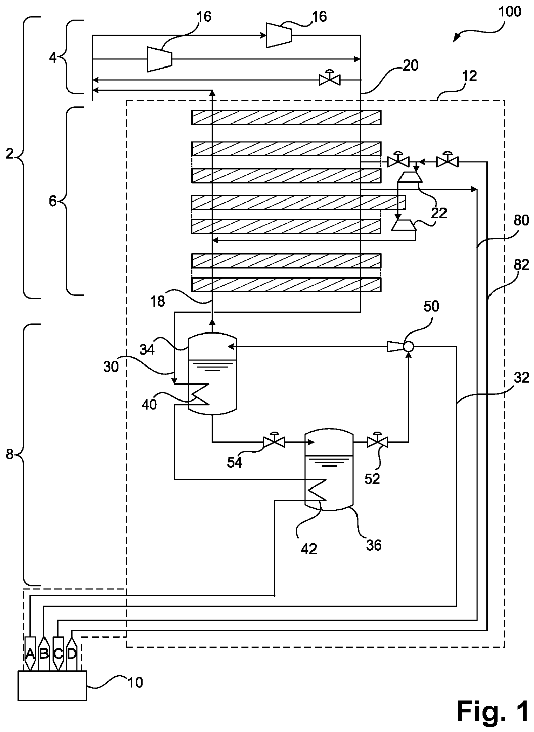

Figur 1 zeigt einen Vorkühlkreis 100 mit zweistufiger Badkühlung gemäß einer bevorzugten Ausführungsform der Erfindung. Der Vorkühlkreis umfasst eine Helium-Kälteanlage 2, die ein Kompressorsystem 4 bzw. Verdichtersystem und ein Wärmetauschersystem 6 einschließt, und ein Badkühlungsystem 8, die einen ersten Kühlbadbehälter 34 und einen zweiten Kühlbadbehälter 36 einschließt. Zusammen mit einer Kälteabgabeeinrichtung 10, die zum Wärmeaustausch mit wenigstens einem zu kühlenden Verbraucher eingerichtet ist, wird ein geschlossener Vorkühlreislauf (für den weiter zu kühlenden Verbraucher) gebildet, wobei als Kühlmedium Helium verwendet wird.

Das Kompressorsystem 4 umfasst wenigstens einen Kompressor 16, der durch eine Rückführleitung 18 rückströmendes Helium verdichtet. Ein Druck des rückströmenden Heliums liegt typischerweise bei etwa 1,05 bar. Ein Druck des verdichteten Heliums liegt typischerweise im Bereich von 7 bis 18 bar, vorzugsweise im Bereich von 10 bis 15 bar. Weiterhin kann im oder am Kompressorsystem eine nicht weiter eingezeichnete Wärmeabgabeeinrichtung vorgesehen sein, über die Wärme an die Umgebung abgegeben werden kann.

Das verdichtete Helium wird über eine Zuführleitung 20 einer Zuleitung 30 zugeführt. Die Rückführleitung 18 und die Zuführleitung 20 verlaufen durch das Wärmetauschersystem 6, so dass zwischen dem rückströmenden Helium und dem verdichteten Helium im Gegenstrom ein Wärmeaustausch ermöglicht wird.

Weiterhin können in der Kälteanlage 2 eine oder mehrere Turbinen 22 vorgesehen sein, über die verdichtetes Helium, das der Zuführleitung an einer Stelle im Wärmetauschersystem 6 entnommen wird, auf das Druckniveau der Zuführleitung entspannt wird, und dem rückströmenden Helium in der Rückführleitung an einer (möglicherweise anderen) Stelle im Wärmetauschersystem wieder zugeführt wird, so dass im Prinzip ein Brayton-Zyklus gebildet wird.

Die durch das Badkühlsystem 8 verlaufende Zuleitung 30 verläuft zunächst durch einen in einem Fußraum des ersten Kühlbadbehälters 34 angeordneten ersten Wärmetauscher 40 und anschließend durch einen in einem Fußraum des zweiten Kühlbadbehälters 36 angeordneten zweiten Wärmetauscher 42. Die Kühlbadbehälter sind jeweils so eingerichtet, dass sich im Fußraum ein Heliumbad, d.h. Helium im flüssigen Zustand, befindet und sich im Kopfraum Heliumdampf befindet, der sich im Gelichgewicht mit dem flüssigen Helium im Fußraum befindet. Einem Druck, d.h. einem Gleichgewichtsdruck, im Kühlbadbehälter kann also eine entsprechende Temperatur zugeordnet werden (entsprechend der Dampfdruckkurve). Im ersten Kühlbadbehälter 34 beträgt der Druck vorzugsweise etwa 1,25 bar, d.h. liegt im Bereich von 1,0 bar bis 1,5 bar. Im zweiten Kühlbadbehälter 36 beträgt der Druck vorzugsweise etwa 0,5 bar, d.h. liegt im Bereich von 0,4 bar bis 0,65 bar. Der Fußraum des ersten Kühlbadbehälters 34 ist über eine Leitung mit dem zweiten Kühlbadbehälter 36 bzw. dessen Kopfraum verbunden, um letzteren Helium zuführen zu können, wobei in der Leitung ein Ventil 54 vorgesehen ist, um diese Heliumzuführung steuern zu können.

Insgesamt kann mittels der zweistufigen Badkühlung (im ersten und zweiten Kühlbadbehälter 34, 36) eine Temperatur des Heliums, das der Kälteabgabeeinrichtung 10 zugeführt wird, auf 3,6 K oder weniger abgesenkt werden.

Nachdem das Helium über die Zuleitung 30 der Kälteabgabeeinrichtung 10 zugeleitet und durch die Kälteabgabeeinrichtung zum Kühlen des wenigstens eines Verbrauchers verwendet wurde, wird das Helium von der Kälteabgabeeinrichtung in die Rückleitung 32 geleitet.

Die Rückleitung 32 ist mit einem Ejektor 50 verbunden, so dass durch die Rückleitung von der Kälteabgabeeinrichtung zurückgeleitetes Helium als Treibstrom im Ejektor verwendet werden kann, um Heliumdampf aus dem zweiten Kühlbadbehälter 36 anzusaugen und auf den Druck des ersten Kühlbadbehälter 34 anzuheben und in diesen auszustoßen. Entsprechend ist eine Treibstromöffnung des Ejektors mit der Rückleitung verbunden, eine Ansaugöffnung des Ejektors mit dem Kopfraum des zweiten Kühlbadbehälters (über eine Leitung) verbunden und eine Ausstoßöffnung des Ejektors mit dem Kopfraum des ersten Kühlbadbehälters (über eine Leitung) verbunden. Eine weitere Verflüssigung des Heliums kann auf diese Weise im Vorkühlkreis vermieden werden. In der Verbindungleitung zwischen Kopfraum des zweiten Kühlbadbehälters 36 und dem Ejektor 50 bzw. dessen Ansaugöffnung ist vorzugsweise ein Ventil 52 vorgesehen, um den Dampfstrom vom Kopfraum des zweiten Kühlbadbehälters zum Ejektor steuern zu können.

Der Kopfraum des ersten Kühlbadbehälters 34 ist mit der Rückführleitung 20 der Kälteanlage 2 verbunden, so dass der Heliumkreislauf geschlossen wird.

Weiterhin kann vorgesehen sein, einen Schildkältestrom bereitzustellen, der vom Verbraucher für eine äußere Kühlung verwendet werden kann. Dazu sind beispielsweise eine Schildstromzuleitung 80 und eine Schildstromrückleitung 82 vorgesehen, wobei über die Schildstromzuleitung 80 aus dem Wärmetauschersystem 6 bzw. der Zuführleitung 18 entnommenes verdichtetes Helium zum Verbraucher geleitet wird und das Helium über die Schildstromrückleitung 82 wieder in das Wärmetauschersystem 6 eingespeist wird, z.B. über die Turbinen 22.

Die Elemente des Vorkühlkreises sind mit Ausnahme des Kompressorsystems 4 vorzugsweise in einer Kältebox 12 angeordnet, d.h. von wärmeisolierenden Wänden umgeben. Ebenso sind die Leitungen zu und von der Kälteabgabeeinrichtung 10 von wärmeisolierenden Wänden umgeben. Jeweils durch gestrichelte Linien angedeutet.

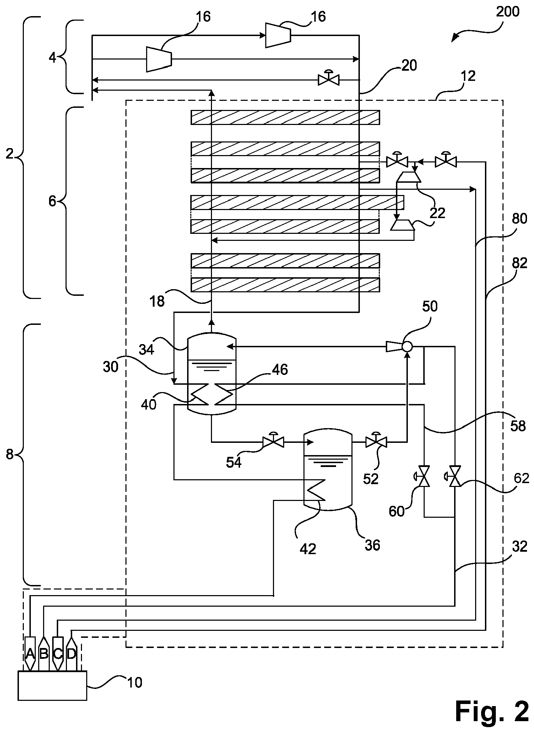

Figur 2 zeigt einen Vorkühlkreis 200 mit einer variabel ausgelegten zweistufigen Badkühlung gemäß einer anderen bevorzugten Ausführungsform der Erfindung. Diese Ausführungsform entspricht größtenteils der in Figur 1 gezeigten Ausführungsform. Im Folgenden wird daher im Wesentlichen lediglich auf unterschiedliche bzw. zusätzliche Elemente eingegangen und auf die erneute Erläuterung von Elementen, die bereits im Zusammenhang mit Figur 1 erläutert wurden, verzichtet.

Im Unterschied zu Figur 1 ist hier zusätzlich eine Nebenrückleitung 58 vorgesehen. Die Nebenrückleitung ist mit einer Abzweigung von der Rückleitung 32 verbunden, so dass von der Kälteabgabeeinrichtung 10 kommendes Helium teilweise aus der Rückleitung abgeleitet bzw. abgezweigt werden kann. In der Nebenrückleitung und der Rückleitung sind Ventile 60, 62 vorgesehen, um die Heliumflüsse in die Nebenrückleitung bzw. die Rückleitung steuern zu können.

Die Nebenrückleitung 58 führt durch einen im Fußraum des ersten Kühlbadbehälters 34 angeordneten vierten Wärmetauscher 46 und wird anschießend, vor dem Ejektor 50, wieder mit der Rückleitung 32 zusammengeführt. Durch die Kühlung des durch die Nebenrückleitung geleiteten Teils des Heliums kann die Temperatur an der Treibstromöffnung des Ejektors beeinflusst werden, was eine Einstellung (indirekt, mittels der Ventile 60, 62 in der Nebenrückleitung bzw. Rückleitung) des Betriebspunkts des Ejektors 50 ermöglicht. Der Vorkühlkreis kann somit mit unterschiedlichen Belastungen benutzt werden, da der Heliumfluss wesentlich durch den Betriebspunkt des Ejektors bestimmt ist. Z.B. können unterschiedlich viele zu kühlende Verbraucher über die Kälteabgabeeinrichtung 10 mit Kälte versorgt werden.

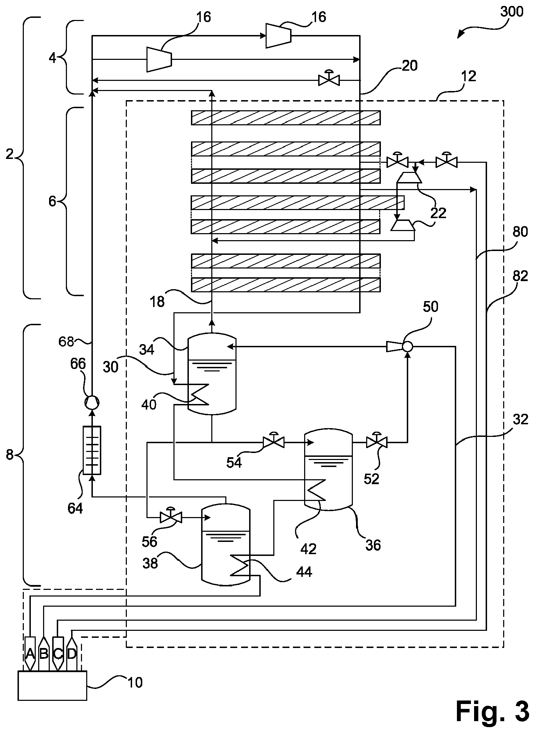

Figur 3 zeigt einen Vorkühlkreis 300 mit einer dreistufigen Badkühlung gemäß einer weiteren bevorzugten Ausführungsform der Erfindung. Diese Ausführungsform entspricht größtenteils der in Figur 1 gezeigten Ausführungsform. Im Folgenden wird daher im Wesentlichen lediglich auf unterschiedliche bzw. zusätzliche Elemente eingegangen und auf die erneute Erläuterung von Elementen, die bereits im Zusammenhang mit Figur 1 erläutert wurden, verzichtet.

Diese Ausführung umfasst zusätzlich einen dritten Kühlbadbehälter 38, wobei die Zuleitung 32 nach dem zweiten Kühlbadbehälter 36 durch einen in einem Fußraum des dritten Kühlbadbehälters 38 angeordneten dritten Wärmetauscher 44 geführt wird. Im dritten Kühlbadbehälter 38 liegt wieder ein Gleichgewicht zwischen flüssigem Helium im Fußraum und Heliumdampf im Kopfraum vor. Der Druck beträgt dabei vorzugsweise etwa 0,2 bar, d.h. liegt im Bereich von 0,1 bar bis 0,3 bar. Auf diese Weise kann eine weitere Temperaturabsenkung des durch die Zuleitung der Kälteabgabeeinrichtung zugeführten Heliums erreicht werden. Beispielsweise kann eine Temperatur unter 3 K erreicht werden.

Eine Vakuumpumpe 64 ist über eine Leitung mit einem Kopfraum des dritten Kühlbadbehälters 38 verbunden und eingerichtet, Heliumdampf aus dem Kopfraum abzupumpen. Das abgepumpte Helium wird über eine Leitung 68, in der ein Verdichter 66 angeordnet ist, in die Rückführleitung 18 der Kälteanlage 2 geleitet. Der Verdichter dient dazu, den Druck des Heliums auf das Niveau in der Rückführleitung anzuheben.

Der Fußraum des ersten Kühlbadbehälters 34 ist über eine Leitung mit dem dritten Kühlbadbehälter 38 bzw. dessen Kopfraum verbunden, um diesem Helium zuführen zu können, wobei in der Leitung ein Ventil 56 vorgesehen ist, um diese Heliumzuführung steuern zu können.

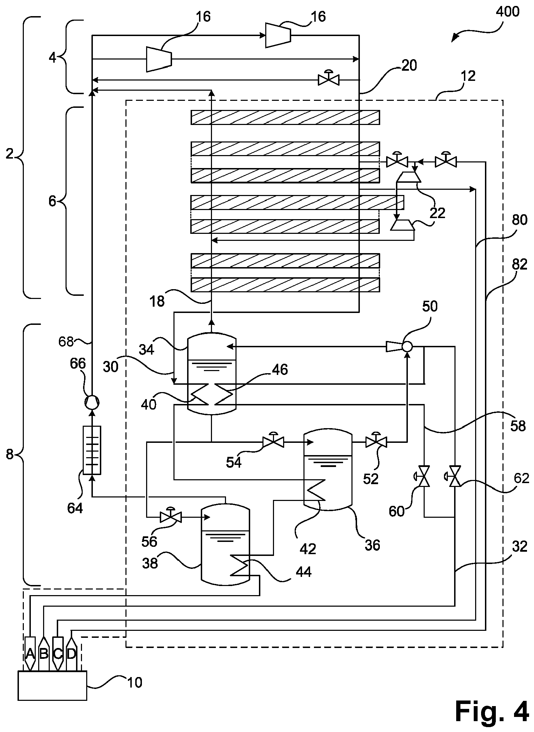

Es ist ebenso möglich die Ausführungsformen der Figuren 2 und 3 zu kombinieren, d.h. in der Ausführung gemäß Figur 2 zusätzlich eine dritte Kühlstufe, d.h. einen dritten Kühlbadbehälter, eine Vakuumpumpe, einen Verdichter und die entsprechenden Leitungen/Ventile, gemäß Figur 3 vorzusehen. Ein entsprechender Vorkühlkreis 400 ist in Figur 4 dargestellt. Alle Elemente dieses Vorkühlkreises wurden bereits im Zusammenhang mit den Figuren 1 bis 3 erläutert.

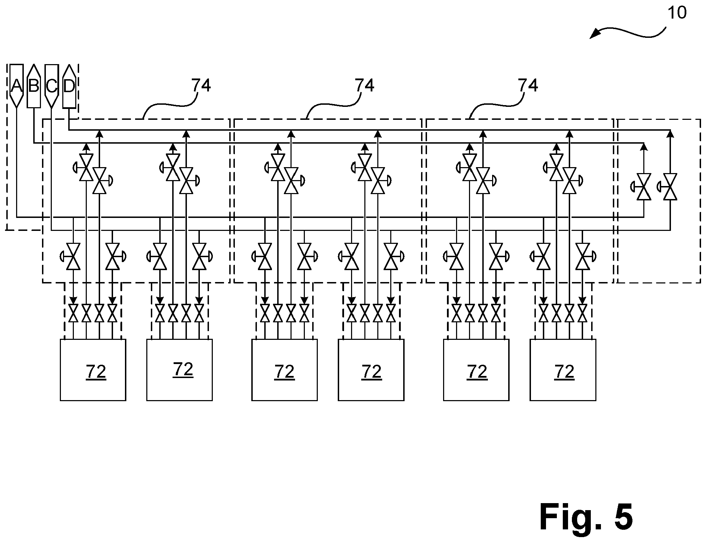

Figur 5 zeigt eine Kälteabgabeeinrichtung 10, die mit zu kühlenden Verbrauchern 72, insbesondere Mischungskryostaten, verbunden ist. Diese Kälteabgabeeinrichtung 10 kann insbesondere für jede der Ausführungen entsprechend der Figuren 1, 2, 3 verwendet werden. Die Zuordnung der Anschlüsse ist in den Figuren durch Pfeile gekennzeichnet, die mit den Buchstaben 'A', 'B', 'C' und 'D' versehen sind.

Die Kälteabgabeeinrichtung 10 umfasst mehrere (hier beispielsweise drei) Ventilgruppen 74, in denen jeweils mit der Zuleitung 32 bzw. der Rückleitung 34 verbundene Leitungen zu einzelnen Verbrauchern oder Verbrauchergruppen 72 vorgesehen sind. Diese Leitungen sind in den Ventilgruppen mit Ventilen versehen, so dass das Helium aus der Zuleitung gezielt zu einzelnen Verbrauchern geleitet und von diesen in die Rückleitung geleitet werden kann. Die Verbraucher 72 sind also in unabhängiger Weise voneinander mit der Zuleitung ('A') und der Rückleitung ('B') verbindbar und trennbar. Dies ist besonders zusammen mit den Vorkühlkreisen 200, 400 der Figuren 2 und 4 vorteilhaft, die einen Teillastbetrieb ermöglichen.

In den Ventilgruppen 74 wird ebenso Leitungen und Ventile für einen Schildkältestrom vorgesehen, über die dieser von der Schildstromzuleitung ('C') zu den Verbrauchern und wieder zurück zu der Schildstromrückleitung ('D') geleitet werden kann. Es wird also ein Schildkreislauf gebildet.

Vorzugsweise ist wieder eine Kältebox oder sind mehrere Kälteboxen vorgesehen, innerhalb derer die Ventilgruppen und vorzugsweise auch Verbraucher, insbesondere die Mischungskryostaten, angeordnet sind.

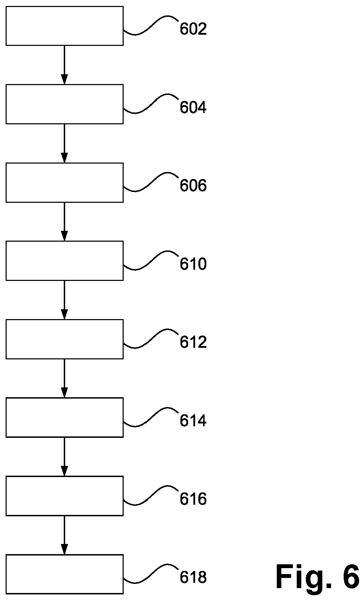

Figur 6 zeigt das erfindungsgemäße Verfahren gemäß einer bevorzugten Ausführungsform. Die einzelnen Schritte sind Teil eines Kreislaufs, den das Helium durchläuft. In Schritt 602 wird das rückströmende Helium verdichtet (etwa mittels des Kompressorsystems). Der dabei erreichte Druck liegt im Bereich von 7 bis 18 bar, bevorzugt von 10 bis 15 bar.

Das verdichte Helium wird in Schritt 604 durch ein erstes Kühlbad und ein nachfolgendes zweites Kühlbad geleitet, um Helium in einem überkritischen Zustand zu erhalten. Im bevorzugten Schritt 606 wird das Helium nach dem zweiten Kühlbad durch ein drittes Kühlbad geleitet. Die Kühlbäder stehen im Gleichgewicht mit einem entsprechenden ersten, zweiten bzw. dritten Heliumdampf. Der Gleichgewichtsdruck entspricht dabei jeweils dem vorstehend im Zusammenhang mit dem ersten, zweiten bzw. dritten Kühlbadbehälter genannten Druck.

Das überkritische Helium wird in Schritt 610 zu einer Kälteabgabeeinrichtung geleitet, die mit dem wenigstens einen zu kühlenden Verbraucher in Wärmeaustausch steht.

In Schritt 612 wird ein Rückstrom des Heliums von der Kälteabgabeeinrichtung zu einer Treibstromöffnung eines Ejektors geleitet. Optional kann in Schritt 614 ein Abzweigen mindestens eines Teils des Rückstroms, um einen Nebenrückstrom zu bilden, ein Leiten des Nebenrückstroms durch das erste Kühlbad und anschließend ein Leiten in den Rückstrom durchgeführt werden.

In Schritt 616 erfolgt ein Ansaugen durch den Ejektor des zweiten Heliumdampfes, der im Gleichgewicht mit dem zweiten Kühlbad steht, und ein Zuführen zu dem ersten Heliumdampf, der im Gleichgewicht mit dem ersten Kühlbad steht.

Der erste Heliumdampf wird in Schritt 618 abgeleitet, um das rückströmende Helium zu erhalten, das in Schritt 602 verdichtet wird, so dass der Kreislauf vervollständigt wird.

## Patentansprüche

1. Vorkühlkreis (100, 200, 300, 400) zur Helium-Kälteversorgung wenigstens eines zu kühlenden Verbrauchers (72), umfassend
eine Zuleitung (30) und eine Rückleitung (32), die über eine Kälteabgabeeinrichtung (10) miteinander verbunden sind, wobei die Kälteabgabeeinrichtung dazu eingerichtet ist, Wärme mit dem wenigstens einen zu kühlenden Verbraucher zu tauschen;
eine Helium-Kühlanlage (2), die dazu eingerichtet ist, Wärme an die Umgebung abzugeben, rückströmendes Helium zu verdichten und das verdichtete Helium in die Zuleitung zu leiten;
einen ersten und einen zweiten Kühlbadbehälter (34, 36), wobei die Zuleitung durch einen in einem Fußraum des ersten Kühlbadbehälters (34) angeordneten ersten Wärmetauscher (40) und in Richtung der Kälteabgabeeinrichtung nachfolgend durch einen in einem Fußraum des zweiten Kühlbadbehälters (36) angeordneten zweiten Wärmetauscher (42) verläuft, und wobei ein Kopfraum des ersten Kühlbadbehälters über eine Rückführleitung (18) mit der Helium-Kühlanlage verbunden ist, um dieser das rückströmende Helium zuzuführen;
einen Ejektor (50) mit einer Treibstrom-Öffnung, einer Ansaug-Öffnung und einer Ausstoß-Öffnung, wobei die Treibstrom-Öffnung mit der Rückleitung verbunden ist, die Ansaug-Öffnung mit einem Kopfraum des zweiten Kühlbadbehälters verbunden ist, und die Ausstoß-Öffnung mit dem Kopfraum des ersten Kühlbadbehälters verbunden ist, wobei der Ejektor eingerichtet ist, durch die Rückleitung von der Kälteabgabeeinrichtung rückströmendes Helium als Treibstrom zu verwenden, um Heliumdampf aus dem zweiten Kühlbadbehälter anzusaugen und auf den Druck des ersten Kühlbadbehälters anzuheben.

2. Vorkühlkreis (200, 400) nach Anspruch 1,
wobei eine Nebenrückleitung (58), die nach dem Verbraucher von der Rückleitung (32) abgezweigt ist, durch einen in dem Fußraum des ersten Kühlbadbehälters (34) angeordneten vierten Wärmetauscher (46) verläuft, und vor der Treibstrom-Öffnung des Ejektors in die Rückleitung mündet;
wobei bevorzugt in der Nebenrückleitung und/oder in der Rückleitung parallel zur Nebenrückleitung wenigstens ein Ventil (60, 62) angeordnet ist, um den Durchfluss durch die Nebenrückleitung zu steuern.

3. Vorkühlkreis (300, 400) nach einem der vorstehenden Ansprüche, umfassend
einen dritten Kühlbadbehälter (38), wobei die Zuleitung (30) nachfolgend auf den zweiten Kühlbadbehälter durch einen in einem Fußraum des dritten Kühlbadbehälters angeordneten dritten Wärmetauscher (44) verläuft, und wobei ein Kopfraum des dritten Kühlbadbehälters mit einer Vakuumpumpe (64) verbunden ist, die dazu eingerichtet ist, Heliumdampf aus dem Kopfraum abzupumpen und der Helium-Kühlanlage zuzuführen, wobei bevorzugt ein Verdichter (66) vorgesehen ist, der ein Druckniveau des abgepumpten Heliums auf ein Druckniveau der Helium-Kühlanlage anhebt.

4. Vorkühlkreis (100, 200, 300, 400) nach einem der vorstehenden Ansprüche,
wobei der erste Kühlbadbehälter (34) dazu eingerichtet ist, im Fußraum flüssiges Helium aufzunehmen, das im Gleichgewicht mit Heliumdampf im Kopfraum steht, wobei ein im Bereich von 1,0 bar bis 1,5 bar liegt, und
wobei der zweite Kühlbadbehälter (36) dazu eingerichtet ist, im Fußraum flüssiges Helium aufzunehmen, das im Gleichgewicht mit Heliumdampf im Kopfraum steht, wobei ein zweiter Gleichgewichtsdruck bevorzugt im Bereich von 0,4 bar bis 0,65 bar liegt, und
wobei, falls abhängig von Anspruch 3, der dritte Kühlbadbehälter (38) dazu eingerichtet ist, im Fußraum flüssiges Helium aufzunehmen, das im Gleichgewicht mit Heliumdampf im Kopfraum steht, wobei ein dritter Gleichgewichtsdruck bevorzugt im Bereich von 0,1 bar bis 0,3 bar liegt.

5. Vorkühlkreis (100, 200, 300, 400) nach einem der vorstehenden Ansprüche,
wobei die Helium-Kühlanlage (2) wenigstens einen Kompressor (16) umfasst und dazu eingerichtet ist, Helium auf einen Druck im Bereich von 7 bar bis 18 bar, bevorzugt im Bereich von 10 bar bis 15 bar, zu verdichten.

6. Vorkühlkreis (100, 200, 300, 400) nach Anspruch 5,
wobei die Helium-Kühlanlage (2) ein Wärmetauschersystem (6) umfasst, wobei das rückströmende Helium im Gegenstrom zum verdichteten Helium durch das Wärmetauschersystem geleitet wird.

7. Vorkühlkreis (100, 200, 300, 400) nach einem der vorstehenden Ansprüche, wobei die Kälteabgabeeinrichtung (10) einen Schildkreislauf umfasst; und wobei die Helium-Kühlanlage dazu eingerichtet ist, einen Heliumschildstrom bereitzustellen, wobei der Heliumschildstrom von der Helium-Kühlanlage zum Schildkreislauf geleitet und von diesem zurück zur Helium-Kühlanlage geleitet wird.

8. Vorkühlkreis (100, 200, 300, 400) nach einem der vorstehenden Ansprüche,
wobei die Kälteabgabeeinrichtung (10) dazu eingerichtet ist, Wärme mit mehreren zu kühlenden Verbrauchern (72) zu tauschen, wobei die Verbraucher unabhängig voneinander mit der Zuleitung und der Rückleitung verbindbar und trennbar sind.

9. Tieftemperaturanlage umfassend einen geschlossenen Vorkühlkreis nach einem der vorstehenden Ansprüche und wenigstens einen Mischungskryostat, der als der wenigstens eine zu kühlende Verbraucher mit der Kälteabgabeeinrichtung verbunden ist; wobei bevorzugt die Kälteabgabeeinrichtung so eingerichtet ist, dass die Zuleitung und die Rückleitung mit wenigstens einem Heliumbad des wenigstens einen Mischungskryostats verbunden sind.

10. Tieftemperaturverfahren, wobei wenigstens eine Probe in dem wenigstens einen Mischungskryostat einer Tieftemperaturanlage nach Anspruch 9 platziert wird und auf eine Temperatur unter 1 K gekühlt wird.

11. Verfahren zur Helium-Kälteversorgung wenigstens eines zu kühlenden Verbrauchers, umfassend
Verdichten rückströmenden Heliums;
Leiten des verdichteten Heliums durch ein erstes Kühlbad (34) und ein nachfolgendes zweites Kühlbad (36), um Helium in einem überkritischen Zustand zu erhalten;
Leiten des überkritischen Heliums zu einer Kälteabgabeeinrichtung (10), die mit dem wenigstens einen zu kühlenden Verbraucher in Wärmeaustausch steht;
Leiten eines Rückstroms des Heliums von der Kälteabgabeeinrichtung zu einer Treibstromöffnung eines Ejektors (50);
Ansaugen eines zweiten Heliumdampfes, der im Gleichgewicht mit dem zweiten Kühlbad steht, mittels des Ejektors und Zuführen zu einem ersten Heliumdampf, der im Gleichgewicht mit dem ersten Kühlbad steht;
Ableiten des ersten Heliumdampfes, um das rückströmende Helium zu erhalten.

12. Verfahren nach Anspruch 11, umfassend
Abzweigen mindestens eines Teils des Rückstroms, um einen Nebenrückstrom zu bilden;
Leiten des Nebenrückstroms durch das erste Kühlbad und anschließend in den Rückstrom.

13. Verfahren nach einem der Ansprüche 11 oder 12, umfassend
Leiten des verdichteten Heliums durch ein drittes Kühlbad nach dem zweiten Kühlbad.
